# FASCICULE DE BREVET EUROPEEN

(11) **EP 3 961 684 B1**
(45) Date de publication et mention de la délivrance du brevet: **26.07.2023**
(21) Numéro de dépôt: 21193002.9
(22) Date de dépôt: 25.08.2021
(51) Int. Cl.: H01L 21/683

(54) **PROCÉDÉ DE FABRICATION D'UN SUBSTRAT-POIGNÉE DESTINÉ AU COLLAGE TEMPORAIRE D'UN SUBSTRAT**
VERFAHREN ZUR HERSTELLUNG EINES SUBSTRATS ZUM TEMPORÄREN VERKLEBEN EINES SUBSTRATS
METHOD FOR MANUFACTURING A CARRIER SUBSTRATE INTENDED FOR TEMPORARY BONDING OF A SUBSTRATE

(30) Priorité: 27.08.2020 FR 2008749
(43) Date de publication de la demande: 02.03.2022
(73) Titulaire: Commissariat à l'Energie Atomique et aux Energies Alternatives, 75015 Paris (FR)
(72) Inventeur: MONTMEAT, Pierre, 38054 GRENOBLE Cedex 9 (FR); FOURNEL, Frank, 38054 GRENOBLE Cedex 9 (FR); STEWART, Paul, 38054 GRENOBLE Cedex 9 (FR)
(74) Mandataire: Germain Maureau

(56) Documents cités:
- WO-A1-2015/092254
- US-A1- 2017 040 200

## Description

La présente invention concerne un procédé de fabrication d'un substrat-poignée destiné au collage temporaire d'un substrat pour des étapes de traitement en vue d'applications dans les domaines de l'électronique, l'optique ou l'optoélectronique. L'invention concerne également un procédé de fabrication d'un substrat démontable utilisant ce procédé de fabrication.

Les techniques de collage temporaire pour plaque (ou wafer selon la terminologie anglo-saxonne) sont généralement mises au point en vue de permettre la réalisation d'étapes de traitement de la plaque en limitant notamment les risques d'endommagement. Ces techniques utilisent un substrat-poignée sur lequel la plaque, par exemple en matériau semi-conducteur tel que le silicium, est collée de façon temporaire. Elles permettent notamment de facilement manipuler la plaque afin de réaliser des composants électroniques sur ses deux faces. Selon une solution connue, une première plaque qui comporte des circuits sur la face avant est collée au moyen d'un adhésif sur un substrat-poignée temporaire. Le collage temporaire est assuré d'une part par l'étalement de l'adhésif sur la première plaque et d'autre part par la présence d'une couche de démontage antiadhésive sur le substrat support constituant le substrat-poignée. Cette couche antiadhésive facilite le démontage du substrat-poignée en fin de procédé en assurant une faible adhérence entre l'adhésif et le substrat-poignée (< 1000 mJ/m²) et notamment une adhérence beaucoup plus faible que celle entre l'adhésif et la première plaque (> 2000 mJ/m²). Une fois le substrat-poignée retiré, l'adhésif est retiré de la surface de la première plaque.

Lorsque l'adhésif est une formulation liquide, l'étalement sur la première plaque est généralement réalisé par une enduction centrifuge qui est suivie d'un recuit destiné à évacuer les solvants de la formulation initiale.

Dans certains cas particuliers, étaler l'adhésif sur la première plaque n'est pas possible :
- Les composants présents sur la première plaque ou le substrat ne supportent pas les recuits nécessaires à la mise en forme de l'adhésif.
- La surface de la première plaque n'est pas suffisamment mouillante pour assurer un dépôt homogène et couvrant de l'adhésif.
- La première plaque n'est pas compatible avec l'équipement d'étalement (épaisseur, type de matériau, contamination métallique...)
- La topographie de la première plaque n'est pas adaptée au procédé d'étalement ou aux procédés à venir.

Une solution particulièrement intéressante consiste à étaler l'adhésif sur le substrat-poignée en présence de la couche de démontage, avant collage sur la première plaque. Cette possibilité permet d'éviter tout étalement sur la première plaque et les inconvénients associés. Un tel procédé est décrit dans le document US 2017/040200 A1.

Toutefois, la surface de la couche de démontage présente généralement une très faible énergie de surface, qui lui confère un caractère très peu mouillant vis-à-vis de l'adhésif. Dès lors, si l'on dépose un adhésif liquide sur ce type de surface, on observe un démouillage de l'adhésif. Cette configuration rend le collage difficile, voire impossible.

L'un des buts de la présente invention vise à pallier au moins l'un des inconvénients précités. A cet effet, la présente invention propose un procédé de fabrication d'un substrat-poignée, le procédé comprenant les étapes de :
a) fourniture d'un substrat support comprenant une face de réception,
b) dépôt d'une formulation antiadhésive comprenant un premier solvant sur la face de réception du substrat support de sorte à former un film,
c) dépôt d'une formulation liquide sur une face du film, avant l'évaporation complète du premier solvant, la formulation liquide étant destinée à former une couche adhésive, et
d) évaporation du premier solvant de sorte à obtenir un film antiadhésif à partir du film afin d'obtenir le substrat-poignée et d'obtenir une énergie de collage entre le film antiadhésif et la couche adhésive inférieure à 1,2 J/m².

De préférence, l'énergie de collage entre le film antiadhésif et la couche adhésive est inférieure à 0,4 J/m².

Grâce à ce procédé de la présente invention, il est possible de déposer la formulation liquide adhésive sur le film sans démouillage pour ensuite atteindre les propriétés antiadhésives souhaitées du film par évaporation du premier solvant. Un substrat-poignée comportant une couche adhésive déposée sur un film antiadhésif est alors obtenu. Le procédé est ainsi avantageusement dépourvu de toute étape de traitement du film antiadhésif, tel qu'un traitement corona, UV, etc ... classiquement réalisée en vue d'obtenir une meilleure accroche de la couche adhésive déposée.

La présente invention est basée sur des résultats d'expériences au cours desquelles les inventeurs ont pu observer que le caractère antiadhésif d'un film obtenu par dépôt d'une formulation liquide varie et augmente avec la diminution de la teneur du solvant initialement présente dans le film.

En effet, un film antiadhésif comprenant un matériau antiadhésif tel qu'un polymère organo-silane ou un polymère fluoré présente une très faible énergie de surface, ce qui est connu pour conduire au démouillage d'un dépôt effectué sur la surface. Comme on le verra ci-après dans la description détaillée de l'invention, un tel film présente aussi un angle de goutte à l'eau très important et supérieur à 90 degrés. Les inventeurs de la présente invention ont comparé l'énergie de surface et l'angle de goutte obtenu pour différents dépôts de formulations hydrophobes contenant un matériau hydrophobe en solution dans un premier solvant. A chaque expérience, l'énergie de surface du film antiadhésif obtenu était faible, l'angle de goutte s'est montré inversement élevé et l'étalement de la formulation liquide adhésive a conduit au démouillage.

En étudiant la cinétique de l'évolution de l'angle de goutte d'un film hydrophobe fraîchement déposé, les inventeurs ont pu constater que l'angle de goutte était initialement faible et qu'il augmentait sous atmosphère ambiante. Ils ont constaté que le film ne devenait fortement hydrophobe et que l'énergie de surface devenait la plus faible qu'une fois le premier solvant fortement voire totalement évaporé du film déposé.

Fort de ce constat, les inventeurs ont réalisé des étalements de formulations liquides pour couches adhésives sur la surface du film avant évaporation complète du premier solvant. Dans ces conditions aucun démouillage n'a été observé. Les inventeurs ont alors laissé le premier solvant s'évaporer en présence de la couche adhésive jusqu'au séchage complet du film. Celui-ci s'est structuré et est devenu fortement hydrophobe sans que la couche adhésive ne se désolidarise de sa surface (se reporter aux exemples 1 à 4).

Si l'on considère le paramètre S gouvernant l'étalement d'un liquide sur un substrat, ce paramètre est lié à l'énergie de surface avec S = γₛ(substrat)- γₗ(liquide). Lorsque S < 0 le liquide déposé démouille et lorsque S>0 l'étalement du liquide est possible. Il est préférable pour avoir un bon étalement que S soit cependant supérieur à 5 mJ/m² voire 10 mJ/m².

De préférence, le film formé à l'étape b) présente une énergie de surface γ_{finitial}(film initial), la formulation liquide présente une énergie de surface γₗ(liquide) et lors du dépôt de l'étape b) γ_{finitial}(film initial) > γₗ(liquide) de sorte que la formulation liquide est déposée sans démouillage. Après l'évaporation du premier solvant selon l'étape d), l'énergie de surface du film antiadhésif γs (substrat) est inférieure à γ_{finitial}(film initial) de sorte à avoir l'énergie de collage inférieure à 1.2J/m² et de préférence inférieure à 0.4J/m².

Selon une possibilité de la présente invention, le film antiadhésif présente une énergie de surface γₛ(substrat) inférieure à 25 mJ/m² et de préférence inférieure à 20 mJ/m².

Avantageusement, l'énergie de surface γₗ (liquide) de la formulation liquide est comprise entre 25 et 80 mJ/m².

Dans l'ensemble du document on entend par l'expression 'substrat-poignée' un substrat support (pouvant être un substrat massif ou une structure pouvant comprendre plusieurs couches et/ou substrats), convenant au collage temporaire d'un substrat d'intérêt (wafer fonctionalisé ou non), pour le supporter (ou 'handle' dans la terminologie anglo-saxonne), et notamment pour le manipuler sans risque de l'endommager lors d'application d'étapes de traitement, telles que visées ci-dessous. Le terme 'substrat-poignée' de l'invention peut se traduire par l'expression 'handle substrate' (ou handle wafer) dans la terminologie anglo-saxonne consacrée.

Egalement, dans l'ensemble du présent document, la mesure d'énergie de surface est obtenue par la méthode Owens et Wendt (D. Owens; R. Wendt, J. Appl. Polym. Sci 13 (1969), P. 1741-1747) réalisée sur KRUSS^{®} DSA100, à partir de 3 liquides : eau, éthylène glycol et diiodométhane.

Selon une disposition, la formulation antiadhésive comprend un matériau antiadhésif dilué dans le premier solvant.

Avantageusement, le matériau antiadhésif est un polymère hydrophobe, de préférence un polymère fluoré tel que le EGC 2702 avec le EGC 7200 comme premier solvant, le EGC 1700 avec le EGC 7100 comme premier solvant, (disponibles auprès de 3M^{®}, un perfluorodecyltrichlorosilane (FDTS fourni par Aesar GmbH & Co.) avec l'isooctane comme premier solvant, ou un polymère organo-silane fluoré ou non, tel que l'Octadécyl TricholoroSilane (OTS) fourni par Sigma-Aldrich^{®} avec l'isooctane comme premier solvant.

Selon une possibilité, la formulation liquide comprend un matériau organophile, tel qu'un polymère organique.

Selon un mode de mise en oeuvre, le matériau organophile est un composé liquide, tel que le matériau LC 5200 fourni par la société 3M^{®} ou d'autres polyacrylates.

Selon une variante de réalisation, la formulation liquide comprend un matériau organophile et un deuxième solvant, tel que le matériau BrewerBOND^{®}305, le BsiT09001A fournis par la société Brewer Science ou d'autres polymères adhésifs.

Selon une disposition, l'étape b) est réalisée par étalement par enduction centrifuge de la formulation antiadhésive, par un étalement par immersion ou par pulvérisation. L'étalement par enduction centrifuge est également dénommé étalement à la tournette (ou Spin Coating selon la terminologie anglo-saxonne).

Selon un mode de réalisation particulier, la face de réception du substrat support est soumise à des étapes de nettoyage préalables au dépôt de l'étape b).

Selon une possibilité, le dépôt de la formulation antiadhésive selon l'étape b) est réalisé uniquement sur la face de réception du substrat support.

Selon une possibilité, l'étape c) de dépôt de la formulation liquide est réalisée par étalement par enduction centrifuge.

Avantageusement, le procédé comprend après l'étape c) de dépôt de la formulation liquide, une étape d'évaporation du deuxième solvant.

Avantageusement, l'étape d) conduit à l'évaporation du deuxième solvant. Ce qui permet de faire aussi décroître l'énergie de surface du liquide et donc d'accentuer la faible adhérence recherchée.

Selon une possibilité, l'étape d) comprend l'application d'un traitement thermique.

Selon une variante, l'étape d) est réalisée en plaçant la structure obtenue à l'étape c) sous vide.

Selon une possibilité, l'étape d) d'évaporation est réalisée jusqu'à évaporation totale du premier solvant et du deuxième solvant lorsqu'il est présent. Ainsi, le caractère hydrophobe du film antiadhésif et le caractère démontable du substrat-poignée obtenus sont optimum.

Avantageusement, l'étape c) est réalisée avant l'évaporation complète du premier solvant, de sorte que ladite face du film présente un angle de goutte inférieur à 65 degrés et de préférence inférieur à 60 degrés lors du dépôt de la formulation liquide de l'étape c). La surface du film présentant de telles valeurs d'angle de goutte permet avantageusement de déposer la formulation liquide sans démouillage.

Ceci signifie dans le présent document que lorsque l'angle de goutte à l'eau est inférieur à 65 degrés, il est certain d'éviter tout démouillage. Toutefois, des valeurs de l'angle de goutte à l'eau supérieures à 65 degrés ne signifient pas pour autant qu'il y aura obligatoirement un démouillage. Lorsque l'angle de goutte à l'eau est supérieur à 65 degrés il y a un risque, qui reste limité, qu'un démouillage partiel survienne, sans pour autant empêcher la réalisation de l'invention.

Autrement dit, l'étape c) est réalisée lorsque ladite face du film présente un angle de goutte à l'eau inférieur à 65 degrés et de préférence inférieur à 60 degrés lors du dépôt de la formulation liquide de l'étape c), de sorte à éviter tout risque de démouillage de la formulation liquide.

Dans le présent document, par l'expression 'angle de goutte' il convient de comprendre un 'angle de goutte à l'eau' mesuré sur l'appareil KRUSS^{®} DSA100.

Selon une disposition, l'étape b) et/ou l'étape c) sont réalisées sous pression atmosphérique.

Selon une possibilité, l'étape b) et/ou l'étape c) sont réalisées dans une atmosphère composée d'air, un gaz neutre, par exemple de l'azote ou de l'hélium, ou une combinaison de gaz neutre.

Selon un mode de réalisation, le procédé comprend entre l'étape b) de formation du film et l'étape c) de dépôt de la formulation liquide, la réalisation d'une étape i) de stockage de la structure comprenant le film déposé sur une face de réception d'un substrat support dans une enceinte saturée de premier solvant de sorte à maintenir le premier solvant au sein du film. Cette disposition permet de maintenir au moins en partie la quantité initiale de premier solvant au sein du film pendant plusieurs heures. L'angle de goutte du film avant réalisation de l'étape c) est ainsi maintenu à une très basse valeur, compatible avec un dépôt de la formulation liquide sans démouillage.

Selon une disposition, le stockage selon l'étape i) est réalisé sur plusieurs heures, par exemple 24 heures.

Lorsque l'enceinte reste parfaitement saturée de premier solvant dans le temps, le stockage selon l'étape i) est réalisé sur une durée de plusieurs jours ou davantage.

Pour ce faire, l'enceinte considérée comprend un réacteur doté deux compartiments hermétiques juxtaposés l'un à l'autre et configurés de sorte à permettre une communication fluidique entre les deux. Un premier compartiment est configuré pour recevoir une source de premier solvant destinée à générer une atmophère saturée de premier solvant. Un deuxième compartiment est configuré pour recevoir ladite structure. La communication fluidique est opérée entre les deux compartiments de sorte que la structure est stockée dans une atmosphre saturée en premier solvant sur une durée permettant de conserver la condition suivante : énergie de surface γ_{finitial}(film initial) - énergie de surface γₗ(liquide) > 0.

Selon encore une possibilité, les étapes a) et/ou b) sont réalisées dans une enceinte saturée de premier solvant. Cette disposition évite le déplacement du substrat support dans une enceinte saturée de premier solvant pour la réalisation de l'étape i) dans la mesure où il y est déjà présent.

Lorsque l'étape b) n'est pas réalisée sous une atmosphère saturée en premier solvant, il est déconseillé d'attendre un laps de temps très important pouvant conduire à l'évaporation totale du premier solvant avant de réaliser l'étape c).

Avantageusement, l'étape c) est réalisée avant l'écoulement d'une durée prédéterminée Δt à compter de l'exposition à l'air ambiant (pression atmosphérique sous air, ou sous N2, He) du film formé à l'étape b). Cette exposition à l'air ambiant commence par exemple immédiatement à la fin de la réalisation de l'étape b) ou à la fin de l'étape i) de stockage.

La durée prédéterminée Δt est fonction du caractère volatile du premier solvant.

Selon une possibilité, la durée prédéterminée Δt est déterminée selon la valeur de l'angle de goutte de la surface du film obtenu à l'étape b).

Selon une variante, la durée prédéterminée Δt est déterminée de sorte à conserver la condition suivante : énergie de surface γ_{finitial}(film initial) - énergie de surface γₗ(liquide) > 0.

Selon une possibilité, le substrat support est choisi parmi le silicium, la silice, le verre, le saphir, le SiC, le germanium, un matériau III-V comme AsGa, le GaN ou l'InP, un matériau piézoélectrique comme LNO / LTO ou un métal. Le métal du substrat support est par exemple choisi parmi le molybdène, le tungstène, le titane, le platine et le cuivre.

Selon un autre aspect, l'invention propose un procédé de fabrication d'un substrat démontable, le procédé comprenant les étapes de :
k) fourniture du substrat-poignée obtenu tel que précédemment décrit,
l) fourniture d'un substrat comprenant une face avant et une face arrière, la face arrière étant apte à recevoir des composants électroniques,
m) mise en contact de la face avant du substrat et une face exposée de la couche adhésive du substrat-poignée, de sorte à obtenir un substrat démontable par le collage temporaire du substrat au substrat-poignée.

Avantageusement, le substrat comprend un matériau choisi parmi le silicium, la silice, le verre, le SiC, le saphir, le germanium, un matériau III-V comme AsGa, le GaN ou l'InP, un matériau piézoélectrique comme LNO / LTO ou un métal tel que le molybdène, le tungstène, le platine, le titane et le cuivre par exemple. Le substrat peut également comprendre une structure composite comprenant un ou plusieurs substrats et/ou une ou plusieurs couches de différents matériaux semi-conducteurs ou métalliques.

Selon une disposition, le substrat a déjà subi des étapes de préparations préalables sur la face avant collage ou sur la face arrière, tel que la formation de motifs (patterning en anglais).

De préférence, la face avant du substrat fourni à l'étape m) comprend des composants électroniques.

Avantageusement, dans le cas où le substrat est en verre, le matériau organophile est choisi parmi un matériau liquide tel que le LC5200, pour lequel une réticulation est obtenue par rayonnement UV au travers du substrat de verre. Cette étape permet de finaliser le collage temporaire.

De préférence, le procédé comprend après l'étape m) une étape n) de traitement thermique de renforcement de collage entre le substrat et le substrat-poignée. En fin de réalisation de l'étape n) l'énergie d'adhérence entre le film antiadhésif et la couche adhésive du substrat démontable est comprise entre 150 et 1200 mJ/m².

Dans l'ensemble du présent document, les valeurs d'énergie d'adhérence (ou énergie de collage) sont obtenues par mesure par l'insertion de coin selon Maszara WP et al, J Appl Phys 1988;64:4943.

Selon une possibilité, le traitement thermique de renforcement de collage entre le substrat et le substrat-poignée de l'étape n) participe à finaliser l'évaporation du premier solvant. Il est ainsi possible de réaliser une évaporation partielle du premier solvant à l'étape d) et de réduire le temps nécessaire à la fabrication du substrat-poignée.

Selon une possibilité, le procédé comprend après l'étape m) une étape o) d'application à la face arrière du substrat au moins une étape de traitement destinée à la fabrication de composants électroniques, telle qu'une rectification, un amincissement, un polissage mécano-chimique, une gravure, un dépôt de diélectrique ou de métal, une formation de motifs, une passivation, un traitement thermique, ou une combinaison d'au moins l'un de ces traitements.

De préférence, le procédé comprend une étape p) de détachement à l'interface entre le film antiadhésif et la couche adhésive de sorte à détacher le substrat.

Avantageusement, l'étape p) de détachement est réalisée après l'étape o) de sorte à détacher le substrat traité par au moins une étape de traitement selon l'étape o).

Selon une possibilité, l'étape p) consiste à procéder à une attaque chimique et/ou à appliquer une contrainte mécanique de sorte à séparer le substrat du substrat-poignée. La contrainte mécanique peut consister en l'application d'une lame à l'interface entre le substrat-poignée et le substrat, d'une force de traction ou d'une force de cisaillement. Elle peut être appliquée par exemple en imposant une courbure à la structure constituée du substrat et du substrat-poignée, par exemple par emboutissage sur une préforme adaptée.

Selon une possibilité, après l'étape p) de détachement, le substrat est nettoyé par exemple par une étape de rinçage au limonène puis à l'isopropanol en vue d'éliminer la couche adhésive résiduelle.

Le procédé décrit ci-dessus produit un substrat-poignée destiné au collage temporaire d'un substrat, le substrat-poignée comprenant un substrat support, un film antiadhésif formé sur une face de réception du substrat support et une couche adhésive déposée sur une face du film antiadhésif, le film antiadhésif permettant d'obtenir une énergie de collage entre le film antiadhésif et la couche adhésive inférieure à 1.2 J/m² et de préférence inférieure à 0.4 J/m².

Avantageusement, l'énergie de surface γₛ(substrat) du film antiadhésif est inférieure à l'énergie de surface de la formulation adhésive liquide γₗ(liquide), et de préférence γₗ(liquide) - γₛ(substrat) > 5 J/m² et de préférence encore γₗ(liquide) - γₛ(substrat) ≥ 10 J/m².

Par l'expression énergie de surface γₛ(substrat) du film antiadhésif, il est entendu dans la présent document l'énergie de surface du film antiadhésif dont le solvant présent dans la formulation antiadhésive précurseur s'est évaporé.

Par l'expression 'la couche adhésive déposée sur une face du film antiadhésif', on entend, dans le présent document, un empilement comprenant une couche adhésive disposée au contact direct du film antiadhésif. L'empilement est dépourvu de toute autre couche, film ou colle complémentaire. La couche adhésive et le film antiadhésif de l'empilement sont solidaires. L'empilement présente une énergie d'adhérence comprise entre 150 et 1200 mJ/m².

Avantageusement, le substrat support du substrat-poignée est choisi parmi le silicium, la silice, le verre, le saphir, le SiC, le germanium, un matériau III-V comme AsGa, le GaN ou l'InP, un matériau piézoélectrique comme LNO / LTO ou un métal tel que le molybdène, le tungstène, le titane, le platine et le cuivre. Le film antiadhésif du substrat-poignée comprend un matériau antiadhésif, tel qu'un polymère hydrophobe, de préférence un polymère fluoré tel que le EGC 2702, le EGC 1700, le FDTS, ou un polymère organo-silane tel que le OTS. La couche adhésive du substrat-poignée comprend un matériau organique, tel qu'un polymère organique, de préférence le BrewerBOND^{®}305, le BsiT09001A ou le polymère obtenu à partir du LC5200.

Selon un mode de réalisation particulier, le film antiadhésif présente une épaisseur inférieure à 50 nanomètres et de préférence comprise entre 1 et 15 nm, et la couche adhésive présente une épaisseur comprise entre 10 et 100 micromètres et de préférence entre 20 et 60 micromètres.

Selon une disposition, le film antiadhésif recouvre la totalité de la face de réception du substrat support.

Selon une possibilité, la couche adhésive recouvre la totalité de la face du film sur laquelle la formulation liquide a été déposée.

Selon encore une autre disposition, un substrat démontable est proposé comprenant un substrat collé à un substrat-poignée tel que précédemment décrit, par l'intermédiaire de la couche adhésive déposée sur une face du film antiadhésif, l'énergie d'adhérence du substrat démontable étant compris entre 150mJ/m² et 1200mJ/m².

D'autres aspects, buts et avantages de la présente invention apparaîtront mieux à la lecture de la description suivante d'un mode de réalisation de celle-ci, donnée à titre d'exemples non limitatifs et faite en référence aux dessins annexés. Dans la suite de la description, par souci de simplification, des éléments identiques, similaires ou équivalents des différentes formes de réalisation portent les mêmes références numériques. Les figures ne respectent pas nécessairement l'échelle de tous les éléments représentés de sorte à améliorer leur lisibilité et sur lesquelles on peut voir:
- Figure 1, les étapes a) à d) d'un procédé de fabrication d'un substrat-poignée selon un mode de réalisation de l'invention,
- Figure 2, l'étape i) de stockage d'une structure obtenue à l'étape b) du procédé de fabrication d'un substrat-poignée, et
- Figure 3, les étapes k) à p) d'un procédé de fabrication d'un substrat démontable selon un mode de réalisation de l'invention.

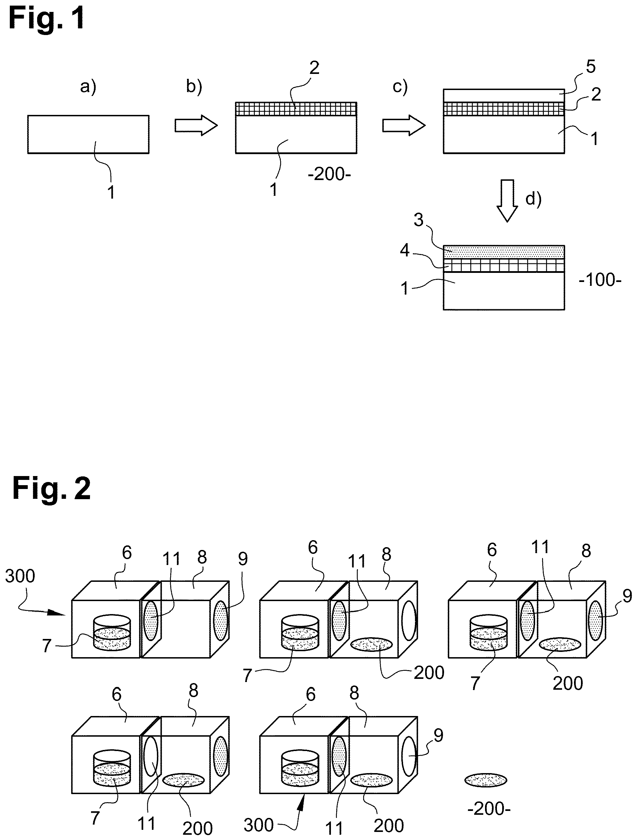

La figure 1 représente un procédé de fabrication d'un substrat-poignée 100 selon un mode de réalisation de la présente invention. Comme illustré, un substrat support 1 est fourni selon l'étape a) du procédé. Le dépôt d'une formulation antiadhésive sur une face de réception du substrat support 1 est réalisé selon l'étape b) du procédé. Ce dépôt conduit à la formation d'un film 2 composé d'un matériau antiadhésif et d'un premier solvant. Selon une possibilité non visible sur la figure 1, le dépôt est réalisé par étalement par enduction centrifuge de la formulation antiadhésive. Selon une variante non illustrée, le dépôt est réalisé par étalement par immersion ou par pulvérisation.

Selon l'étape c) du procédé, une formulation liquide destinée à former une couche adhésive 3 est déposée sur une face exposée du film 2 de sorte à former une couche 5. Cette étape c) est effectuée avant l'écoulement d'une durée prédéterminée Δt à compter de l'exposition dudit film 2 à l'air ambiant pour éviter l'évaporation complète du premier solvant. En effet, la formation de cette couche 5 sans démouillage est rendu possible par le fait que le film 2 contient suffisamment de premier solvant pour que son angle de goutte reste inférieur à 65 degrés et de préférence inférieur à 60 degrés au moment du dépôt de la formulation liquide selon l'étape c). La formulation liquide comprend un matériau organique et un deuxième solvant. Elle présente une energie de surface γₗ (liquide).

Selon une possibilité non visible sur la figure 1, le dépôt de la couche 5 est réalisé par étalement par enduction centrifuge de la formulation liquide.

Une étape d) d'évaporation du premier solvant est ensuite effectuée pour conduire à la formation du film antiadhésif 4 à partir du film 2 obtenu à l'étape b). Le film antiadhésif 4, s'il était structuré seul (sans dépôt de la couche adhésive avant la fin de l'évaporation du solvant) présenterait une énergie de surface ('naturelle') γₛ(substrat) plus faible que l'énergie de surface de la formulation adhésive liquide γₗ(liquide), et de préférence γₗ(liquide) - γₛ(substrat) > 5 J/m² et encore de préférence γₗ(liquide) - γₛ(substrat) ≥10 J/m².

Le deuxième solvant est évaporé de manière concomitante et une couche adhésive 3 est obtenue à partir de la formulation liquide déposée à l'étape c).

Selon une possibilité, l'étape d) est réalisée par application d'un traitement thermique sur la structure obtenue à l'étape c). Le traitement thermique accélère la cinétique d'évaporation du premier solvant et du deuxième solvant le cas échéant.

Selon d'autres variantes de réalisation, l'étape d) est réalisée en laissant la structure obtenue à l'étape c) à température ambiante sous atmosphère ambiante ou bien en plaçant sous vide la structure obtenue à l'étape c).

Le substrat-poignée 100 ainsi obtenu comporte un substrat support 1, un film antiadhésif 4 formé sur la face de réception du substrat support 1, une couche adhésive 3 déposée sur le film antiadhésif 4. Le film antiadhésif s'il était structuré seul présenterait une énergie de surface γₛ(substrat) plus faible que l'énergie de surface de de la formulation adhésive liquide γₗ(liquide), de préférence γₗ(liquide) - γₛ(substrat) > 5 J/m² et encore de préférence γₗ(liquide) - γₛ(substrat) ≥ 10 J/m².

Il est à noter que l'énergie de surface γ_{finitial}(film initial) du film 2 à l'étape c) est supérieure à l'énergie de surface γₗ (liquide) rendant possible le dépôt sans démouillage.

Le substrat support 1 est choisi parmi le silicium, la silice, le verre, le saphir, le SiC, le germanium, un matériau III-V comme AsGa, le GaN ou l'InP, un matériau piézoélectrique comme LNO / LTO ou un métal (par exemple le molybdène, le tungstène, le titane, le platine et le cuivre). Le film antiadhésif 4 comprend un matériau antiadhésif tel qu'un polymère hydrophobe, de préférence un polymère fluoré tel que le EGC 2702, le EGC 1700, un FDTS ou un polymère organo-silane tel que le OTS. Il présente une épaisseur inférieure à 50 nm et de préférence comprise entre 1 et 15 nm. Un film antiadhésif 4 plus épais réduit fortement la capacité d'évaporation du premier solvant et ainsi le caractère antiadhésif du film 4 obtenu à l'étape d). Les mesures d'angles de goutte de tels films antiadhésifs 4 obtenus à l'issu d'un séchage complet sont supérieurs à 80 degrés et de préférence supérieurs à 100 degrés.

La couche adhésive 3 du substrat-poignée 100 comprend un matériau organique, tel qu'un polymère organique, de préférence le BrewerBOND^{®}305, le BsiT09001A fourni par Brewer Science. Son épaisseur est comprise entre 20 et 50 micromètres. Les angles de goutte d'une telle couche adhésive 3 sont compris entre 50 et 60 degrés.

Ces couples de films antiadhésif 4 et de couches adhésives 3 permettent de limiter l'énergie d'adhérence du substrat démontable 400 comme on le verra ci-après.

Selon une variante de réalisation du procédé de fabrication du substrat-poignée 100, illustrée sur la figure 2, l'étape c) est précédée d'une étape i) de stockage de la structure 200 obtenue à l'étape b) comprenant le film 2 formé sur une face de réception du substrat support 1, dans une enceinte 300 saturée de premier solvant de sorte à limiter l'évaporation du premier solvant contenu dans le film 2. Ainsi, l'angle de goutte du film varie peu au cours du stockage et la structure 200 peut être utilisée pour effectuer l'étape c) même après plusieurs heures voire 24 heures ou davantage.

Pour ce faire, les inventeurs ont considéré une enceinte 300 comprenant un réacteur doté deux compartiments hermétiques, juxtaposés l'un à l'autre et configurés de sorte à permettre une communication fluidique entre les deux, comme illustré en figure 2. Un premier compartiment 6 est configuré pour recevoir une source 7 de premier solvant destinée à générer une atmophère saturée de premier solvant. Le deuxième compartiment 8 est configuré pour recevoir ladite structure 200. La succession des étapes de manipulation de l'enceinte 300 en vue du stockage est illustrée par les schémas juxtaposés de la figure 2, suivant un ordre chronologique. Le deuxième compartiment 8 comprend une paroi externe au travers de laquelle est ménagée une porte étanche 9 configurée pour l'introduction de ladite structure fraichement étalée (et pour son retrait). Un dispostif d'ouverture-fermeture 11 hermétique disposé entre les deux compartiments est ouvert pour permettre la circulation du solvant dans les deux compartiments. Ainsi configuré, le réacteur hermétique présente une efficicacité optimale pour éviter l'évaporation du premier solvant contenu dans le film 2 avant de réaliser l'étape c).

Ces précautions prises dans le stockage dans une enceinte 300 saturée en premier solvant et le fait de réaliser l'étape c) avant l'écoulement d'une durée prédéterminée Δt à compter de l'exposition du film 2 à l'air ambiant, (hors de l'enceinte 300, ou bien sous atmosphère d'N2, He), permettent de maintenir l'énergie de surface γ_{finitial}(film initial) supérieure à celle de la formulation liquide γₗ(liquide) et ainsi de déposer la formulation liquide d'un matériau organophile pour former la couche 5 sur un film antiadhésif.

En effet, suivant la cinétique de l'évolution de l'angle de goutte du film 2 après l'étape b), l'angle de goutte augmente avec la durée du contact à l'air (ou de N2, He) et l'évaporation du premier solvant présent dans le film 2. Ainsi, la durée prédéterminée Δt est déterminée en fonction de la valeur de l'angle de goutte directement liée à l'énergie de surface du film. Aussi, la durée prédéterminée Δt est inférieure ou égale à 30 min pour un exemple de matériau EGC 2702 dilué dans un premier solvant EGC 2700 de sorte à maintenir un angle de goutte inférieur à 65 degrés lors de la réalisation de l'étape c).

Selon une variante non visible sur la figure 2, le support 1 est directement fourni dans l'enceinte 300 saturée en premier solvant (étape a), puis l'étape b) de dépôt de la formulation antiadhésive en vue de la formation du film 2 est également réalisée dans l'enceinte 300 saturée en premier solvant. Une étape de stockage i) peut prolonger la station de la structutre 200 dans l'enceinte 300 avant de réaliser l'étape c).

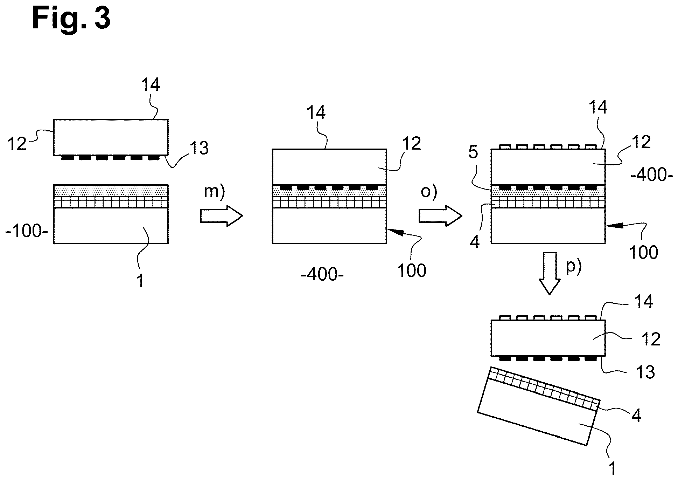

Selon un autre aspect illustré à la figure 3, l'invention propose la fabrication d'un substrat démontable 400. Pour ce faire, un substrat 12 présentant une face avant 13 et une face arrière 14 et un substrat-poignée 100 tel que précédemment décrit sont fournis selon les étapes k) et I) du procédé. Une face exposée de la couche adhésive 3 du substrat-poignée 100 est mise en contact avec la face avant 13 du substrat 12 pour un collage temporaire selon l'étape m) du procédé permettant l'obtention du substrat démontable 400. Puis un traitement thermique de renforcement de collage est appliqué selon une étape n) (non visible sur les figures). Typiquement, l'énergie d'adhérence du substrat démontable 400 ainsi obtenu est comprise entre 150 et 1200 mJ/m².

Le matériau du substrat 12 est choisi parmi le silicium, verre, saphir, germanium, SiC, un matériau III-V comme AsGa, GaN, InP, un matériau piézoélectrique comme LNO / LTO ou un métal tel que le molybdène, le tungstène, le titane, le platine et le cuivre, selon la nature des opérations ultérieures souhaitées.

Selon une disposition non visible sur les figures, lorsque la formulation liquide est du LC 5200 fourni par 3M^{®}, le substrat 12 est avantageusement en verre pour permettre l'insolation du composé LC5200 au travers du verrre et finaliser le collage temporaire avec le substrat 12.

Selon une étape n) du procédé illustré sur la figure 2, le substrat démontable 400 obtenu est soumis à l'application d'une étape de traitement o) destinée à la fabrication de composants électroniques et appliquée sur la face arrière 14 exposée du substrat 12 (c'est-à-dire la surface libre de tout collage ou couche complémentaire vu que la face avant 13 est collée au substrat-poignée 100). Cette étape de traitement comprend par exemple une rectification, un amincissement, un polissage mécano-chimique, une gravure, un dépôt de diélectrique ou de métal, une formation de motifs, une passivation, un traitement thermique, ou une combinaison d'au moins l'un de ces traitements.

Une étape p) de détachement est ensuite réalisée sur le substrat démontable 400 ainsi préparé de sorte à détacher le substrat 12 au moins partiellement traité ou fonctionnalisé. Cette étape p) de détachement se fait classiquement avec un enchaînement d'actions chimiques et/ou mécaniques.

Voici ci-dessous quelques exemples témoins et des exemples de réalisation du procédé de fabrication d'un substrat-poignée 100 et d'un substrat démontable 400 selon la présente invention.

Les exemples suivants sont réalisés au moyen de plaques de silicium de 200 mm de diamètre.

### Exemple 1 : Film antiadhésif 4 comprenant le polymère fluoré EGC 2702

Le polymère fluoré EGC 2702 est commercialisé en solution dans le solvant EGC 7200.

Témoins : Sur une plaque de silicium, on étale par enduction centrifuge 40 µm de BrewerBOND^{®}305 disponible auprès de la société Brewer Science. Le substrat est ensuite recuit à 200°C puis collé à 200°C à une seconde plaque de silicium. L'adhérence de cette structure est évaluée à 2000 mJ/m².

Sur une plaque de silicium, on étale un film d'EGC 2702 qui est recuit à 150°C. La surface présente un angle de goutte à l'eau de 105°. L'étalement par enduction centrifuge de 40 µm de l'adhésif BrewerBOND^{®}305 à la surface de ce substrat traité conduit à un démouillage de l'adhésif.

Exemple de réalisation de l'invention : Sur un substrat support 1 de silicium, un film d'EGC 2702 dans le premier solvant l'EGC 7200 est étalé selon l'étape b) du procédé. Après l'écoulement d'une durée prédéterminée Δt de 20 min après étalement, cette structure 200 est stockée selon l'étape i) dans une enceinte 300 saturée en EGC 7200. Au bout d'un jour, la structure 200 est extraite de l'enceinte 300 et une formulation liquide de BrewerBOND^{®}305 est étalée sans attendre par enduction centrifuge selon l'étape c) en vue de former une couche adhésive 3 de 40 µm sur la surface du film 2. La couche adhésive 3 est homogène et aucun démouillage n'est observé. L'ensemble est recuit par un traitement thermique à 200°C pendant 5 minutes selon l'étape d) du procédé de sorte à obtenir le substrat-poignée 100.

La mise en contact à 200°C de ce substrat-poignée 100 avec une face arrière 14 d'un substrat de silicium selon l'étape m) conduit à l'obtention d'un substrat démontable 400 présentant une faible énergie adhérence de 400 mJ/m² qui confirme bien le caractère organophobe et antiadhésif du film fluoré 4 ainsi structuré.

### Exemple 2 : Film antiadhésif 4 comprenant du perfluorodecyltrichlorosilane (FDTS)

Le polymère fluoré FDTS est solubilisé dans l'isooctane.

Témoin : Sur un support de silicium, on étale une formulation liquide de l'adhésif BsiT09001A par enduction centrifuge sur une épaisseur de 50 µm. Ce substrat est ensuite recuit à 200°C pendant 5 minutes puis collé à 200°C à une seconde plaque de silicium. L'adhérence de cette structure est évaluée à 2000 mJ/m².

Exemple de réalisation de l'invention : On vient étaler par immersion sur un substrat support 1 de silicium une formulation comprenant du FDTS en solution dans l'isooctane à 5.10⁻³ mol/L. selon l'étape b) du procédé. L'étalement par immersion consiste à tremper le substrat support 1 dans une solution de FDTS dans l'isooctane pendant 5 minutes. Le film formé présente une épaisseur de 10 nm et l'angle de goutte à l'eau est de 40°. Après l'écoulement d'une durée prédéterminée Δt de 20 min après étalement, cette plaque est placée dans une enceinte 300 saturée en isooctane selon l'étape i). Au bout d'environ 24h, la plaque est extraite de l'enceinte 300, l'angle de goutte à l'eau est de 50 degrés (contre 120 degrés pour le film antiadhésif 4 dont le premier solvant est totalement évaporé). On vient étaler par enduction centrifuge une formulation liquide de l'adhésif BsiT09001A pour former une couche adhésive 3 de 50 µm sur la face du film selon l'étape c). La couche de l'adhésif est homogène et aucun démouillage n'est observé. Un traitement thermique est effectué à 200°C pendant 5 minutes selon l'étape d) du procédé afin d'obtenir le substrat-poignée 100. La mise en contact de ce substrat-poignée 100 à une face d'un substrat de silicium selon l'étape m) suivie d'un traitement thermique appliqué à 200°C selon l'étape n) conduisent à l'obtention d'un substrat démontable 400 présentant une faible énergie adhérence de 900 mJ /m² qui confirme bien le caractère antiadhésif du film fluoré ainsi structuré.

### Exemple 3 : Film antiadhésif 4 comprenant du EGC 1700

Le polymère fluoré EGC 1700 est commercialisé en solution dans le premier solvant EGC 7100.

Témoin : Sur une plaque de silicium, on étale par enduction centrifuge 40 µm de la formulation liquide BrewerBOND^{®}305. Le substrat est ensuite recuit à 200°C puis collé à 200°C à une seconde plaque de silicium. L'énergie d'adhérence de cette structure est évaluée à 2000 mJ/m².

Sur une plaque de silicium, on étale un film d'EGC 1700 qui est recuit à 120°C. La surface présente un angle de goutte à l'eau de 105°. L'étalement par enduction centrifuge de 40 µm de l'adhésif BrewerBOND^{®}305 à la surface de ce substrat ainsi traité conduit à un démouillage de l'adhésif.

Exemple de réalisation de l'invention : Sur un substrat de silicium, on étale une formulation d'EGC 1700 dans le premier solvant EGC 7100 selon l'étape b). Après l'écoulement d'une durée 10 min, on étale par enduction centrifuge 40 µm de la formulation liquide d'adhésif BrewerBOND^{®}305 sur la face du film selon l'étape c). La couche adhésive 3 est homogène et aucun démouillage n'est observé. L'ensemble est recuit à 200°C pendant 5 minutes selon l'étape d). Le collage à chaud (200°C) de ce substrat-poignée 100 à un substrat de silicium conduit à l'obtention d'un substrat démontable 400 présentant une faible énergie d'adhérence de 200 mJ /m² qui confirme bien le caractère organophobe et antiadhésif du film fluoré ainsi structuré.

### Exemple 4 : Film antiadhésif 4 comprenant le composé OTS : CH₃(CH₂)₁₇SiCl₃

Le composé OTS (CH₃(CH₂)₁₇SiCl₃) est mis en solution dans l'isooctane à une concentration de 5.10⁻³ mol/L.

Témoins : Sur une plaque de silicium, on étale par enduction centrifuge 20 µm de la formulation liquide BrewerBOND^{®}305. Le substrat est ensuite recuit à 200°C puis collé à 200°C à une seconde plaque de silicium. L'énergie d'adhérence de cette structure est évaluée à 2000 mJ/m².

Sur une plaque de silicium, on étale un film d'OTS. On greffe ainsi quelques mono couches d'OTS à la surface du silicium. La surface du film présente un angle de goutte à l'eau de 110°. L'étalement par enduction centrifuge de 20 µm de l'adhésif BrewerBOND^{®}305 à la surface de ce substrat ainsi traité conduit à un démouillage de l'adhésif.

Exemple de réalisation de l'invention : Sur un substrat support 1 de silicium, on étale un film d'OTS selon l'étape b). Après l'écoulement d'une durée prédéterminée de 20 min après étalement, cette plaque est stockée selon l'étape i) dans une enceinte 300 saturée en isooctane. Au bout d'un jour, la plaque est extraite de l'enceinte 300 et on vient étaler par enduction centrifuge une formulation liquide d'adhésif BrewerBOND^{®}305 sur sa face pour former une couche adhésive 3 présentant une épaisseur de 20 µm. La couche adhésive 3 est homogène et aucun démouillage n'est observé. L'ensemble est recuit à 200°C selon l'étape d). Le collage à chaud (200°C) de ce substrat-poignée 100 à un substrat de silicium conduit à l'obtention d'un substrat démontable 400 présentant une faible énergie d'adhérence de 80 mJ /m² qui confirme bien le caractère antiadhésif du film ainsi structuré.

Ainsi la présente invention propose un procédé ingénieux, facile à mettre en oeuvre et peu coûteux pour la fabrication d'un substrat-poignée 100 destiné au collage temporaire d'un substrat 12 à traiter.

## Revendications

1. Procédé de fabrication d'un substrat-poignée (100), le procédé comprenant les étapes de :
a) fourniture d'un substrat support (1) comprenant une face de réception,
b) dépôt d'une formulation antiadhésive comprenant un premier solvant sur la face de réception du substrat support (1) de sorte à former un film (2),
c) dépôt d'une formulation liquide sur une face du film (2), avant l'évaporation complète du premier solvant, la formulation liquide étant destinée à former une couche adhésive (3), et
d) évaporation du premier solvant de sorte à obtenir un film antiadhésif (4) à partir du film (2) afin d'obtenir le substrat-poignée (100) et d'obtenir une énergie de collage entre le film antiadhésif (4) et la couche adhésive (3) inférieure à 1.2 J/m².

2. Procédé de fabrication d'un substrat-poignée (100) selon la revendication 1, dans lequel l'étape c) est réalisée lorsque ladite face du film (2) présente un angle de goutte à l'eau inférieur à 65 degrés et de préférence inférieur à 60 degrés lors du dépôt de la formulation liquide à l'étape c), de sorte à éviter tout risque de démouillage de la formulation liquide.

3. Procédé de fabrication d'un substrat-poignée (100) selon l'une des revendications 1 ou 2, comprenant entre l'étape b) de formation du film (2) et l'étape c) de dépôt de la formulation liquide, la réalisation d'une étape i) de stockage de la structure (200) comprenant le film (2) déposé sur une face de réception d'un substrat support (1) dans une enceinte (300) saturée en premier solvant de sorte à maintenir le premier solvant au sein du film (2).

4. Procédé de fabrication d'un substrat-poignée (100) selon l'une des revendications 1 ou 2, dans lequel les étapes a) et / ou b) sont réalisées dans une enceinte saturée de premier solvant.

5. Procédé de fabrication d'un substrat-poignée (100) selon l'une des revendications 1 à 4, dans lequel l'étape d) est réalisée par application d'un traitement thermique.

6. Procédé de fabrication d'un substrat-poignée (100) selon l'une des revendications 1 à 5, dans lequel le substrat support (1) est choisi parmi le silicium, la silice, le verre, le saphir, le SiC, le germanium, un matériau III-V, un matériau piézoélectrique ou un métal, le film antiadhésif (4) comprend un matériau antiadhésif et la couche adhésive (3) comprend un matériau organophile.

7. Procédé de fabrication d'un substrat démontable (400), le procédé comprenant les étapes de :
k) fourniture du substrat-poignée (100) obtenu selon l'une des revendications 1 à 6,
l) fourniture d'un substrat (12) comprenant une face avant (13) et une face arrière (14), la face arrière (14) étant apte à recevoir des composants électroniques,
m) mise en contact de la face avant (13) du substrat (12) et une face exposée de la couche adhésive (3) du substrat-poignée (100), de sorte à obtenir un substrat démontable (400) par collage temporaire du substrat au substrat-poignée (100).

8. Procédé de fabrication d'un substrat démontable (400) selon la revendication 7, dans lequel le procédé comprend après l'étape m) une étape n) de traitement thermique de renforcement de collage entre le substrat (12) et le substrat-poignée (100).

9. Procédé de fabrication d'un substrat démontable (400) selon l'une des revendications 7 ou 8, dans lequel le procédé comprend après l'étape m) une étape o) d'application à la face arrière (14) du substrat (12) d'au moins une étape de traitement destinée à la fabrication de composants électroniques, telle qu'une rectification, un amincissement, un polissage mécano-chimique, une gravure, un dépôt de diélectrique ou de métal, une formation de motifs, une passivation, un traitement thermique, ou une combinaison d'au moins l'un de ces traitements.

10. Procédé de fabrication d'un substrat démontable (400) selon l'une des revendication 8 ou 9, comprenant une étape p) de détachement à l'interface entre le film antiadhésif (4) et la couche adhésive (3) de sorte à détacher le substrat (12).

## Patentansprüche

1. Verfahren zur Herstellung eines Griff-Substrats (100), wobei das Verfahren die Schritte umfasst, zum:
a) Bereitstellen eines Trägersubstrats (1), das eine Aufnahmeseite umfasst,
b) Abscheiden einer Antihaft-Formulierung, die ein erstes Lösungsmittel auf der Aufnahmeseite des Trägersubstrats (1) umfasst, um einen Film (2) zu bilden,
c) Abscheiden einer flüssigen Formulierung auf einer Seite des Films (2), vor der vollständigen Verdampfung des ersten Lösungsmittels, wobei die flüssige Formulierung dazu bestimmt ist, eine Haftschicht (3) zu bilden, und
d) Verdampfen des ersten Lösungsmittels, um einen Antihaft-Film (4) aus dem Film (2) zu erhalten, um das Griff-Substrat (100) zu erhalten, und um eine Klebeenergie zwischen dem Antihaft-Film (4) und der Haftschicht (3) von weniger als 1,2 J/m² zu erhalten.

2. Verfahren zur Herstellung eines Griff-Substrats (100) nach Anspruch 1, wobei der Schritt c) durchgeführt wird, wenn die Seite des Films (2) einen Tropfenwinkel für Wasser kleiner als 65 Grad und vorzugsweise kleiner als 60 Grad beim Abscheiden der flüssigen Formulierung im Schritt c) aufweist, um die Gefahr des Entfeuchtens der flüssigen Formulierung zu vermeiden.

3. Verfahren zur Herstellung eines Griff-Substrats (100) nach einem der Ansprüche 1 oder 2, das zwischen dem Schritt b) zur Formulierung des Films (2) und dem Schritt c) zum Abscheiden der flüssigen Formulierung die Durchführung eines Schrittes i) zum Lagern der Struktur (200), die den Film (2) umfasst, der auf einer Aufnahmeseite eines Trägersubstrats (1) in einem mit dem ersten Lösungsmittel gesättigten Einschluss (300) abgeschieden ist, umfasst, um das erste Lösungsmittel innerhalb des Films (2) zu halten.

4. Verfahren zur Herstellung eines Griff-Substrats (100) nach einem der Ansprüche 1 oder 2, wobei die Schritte a) und/oder b) in einem Einschluss durchgeführt werden, der mit dem ersten Lösungsmittel gesättigt ist.

5. Verfahren zur Herstellung eines Griff-Substrats (100) nach einem der Ansprüche 1 bis 4, wobei der Schritt d) durch Anwenden einer Wärmebehandlung durchgeführt wird.

6. Verfahren zur Herstellung eines Griff-Substrats (100) nach einem der Ansprüche 1 bis 5, wobei das Trägersubstrat (1) aus Silicium, Kieselsäure, Glas, Saphir, SiC, Germanium, einem III-V Werkstoff, einem piezoelektrischen Werkstoff oder einem Metall ausgewählt wird, der Antihaft-Film (4) einen Antihaft-Werkstoff umfasst, und die Haftschicht (3) einen organophilen Werkstoff umfasst.

7. Verfahren zur Herstellung eines demontierbaren Substrats (400), wobei das Verfahren die Schritte umfasst, zum:
k) Bereitstellen des Griff-Substrats (100), das nach einem der Ansprüche 1 bis 6 erhalten wird,
l) Bereitstellen eines Substrats (12), das eine Vorderseite (13) und eine Rückseite (14) umfasst, wobei die Rückseite (14) imstande ist, elektronische Komponenten aufzunehmen,
m) Kontaktanbahnen der Vorderseite (13) des Substrats (12) und einer offengelegten Seite der Haftschicht (3) des Griff-Substrats (100), um ein demontierbares Substrat (400) durch temporäres Verkleben des Substrats an dem Griff-Substrat (100) zu erhalten.

8. Verfahren zur Herstellung eines demontierbaren Substrats (400) nach Anspruch 7, wobei das Verfahren nach dem Schritt m) einen Schritt n) zur Wärmebehandlung zur Verklebungsverstärkung zwischen dem Substrat (12) und dem Griff-Substrat (100) umfasst.

9. Verfahren zur Herstellung eines demontierbaren Substrats (400) nach einem der Ansprüche 7 oder 8, wobei das Verfahren nach dem Schritt m) einen Schritt o) zum Anwenden auf die Rückseite (14) des Substrats (12) mindestens eines Behandlungsschrittes, der zur Herstellung von elektronischen Komponenten bestimmt ist, wie Schleifen, Verdünnen, mechanisch-chemisches Polieren, Gravieren, Abscheiden eines Dielektrikums oder von Metall, eine Bildung von Motiven, eine Passivierung, eine Wärmebehandlung, oder eine Kombination mindestens einer dieser Behandlungen umfasst.

10. Verfahren zur Herstellung eines demontierbaren Substrats (400) nach einem der Ansprüche 8 oder 9, das einen Schritt p) zum Ablösen an der Schnittstelle zwischen dem Antihaft-Film (4) und der Haftschicht (3) umfasst, um das Substrat (12) abzulösen.

## Claims

1. A method for manufacturing a handle substrate (100), the method comprising the steps of:
a) supplying a support substrate (1) comprising a receiving face,
b) depositing an anti-adhesive formulation comprising a first solvent on the receiving face of the support substrate (1) so as to form a film (2),
c) depositing a liquid formulation on one face of the film (2), before the complete evaporation of the first solvent, the liquid formulation being intended to form an adhesive layer (3), and
d) evaporating the first solvent so as to obtain an anti-adhesive film (4) from the film (2) in order to obtain the handle substrate (100) and to obtain a bonding energy between the anti-adhesive film (4) and the adhesive layer (3) lower than 1.2 J/m².

2. The method for manufacturing a handle substrate (100) according to the claim 1, wherein step c) is carried out when said face of the film (2) has a water drop angle smaller than 65 degrees and preferably smaller than 60 degrees when depositing the liquid formulation in step c), so as to avoid any risk of dewetting of the liquid formulation.

3. The method for manufacturing a handle substrate (100) according to any of claims 1 or 2, comprising between step b) of forming the film (2) and step c) of depositing the liquid formulation, performing a step i) of storing the structure (200) comprising the film (2) deposited on a receiving face of a support substrate (1) in an enclosure (300) saturated with the first solvent so as to maintain the first solvent within the film (2).

4. The method for manufacturing a handle substrate (100) according to any of claims 1 or 2, wherein steps a) and / or b) are carried out in an enclosure saturated with the first solvent.

5. The method for manufacturing a handle substrate (100) according to any of claims 1 to 4, wherein step d) is carried out by applying a heat treatment.

6. The method for manufacturing a handle substrate (100) according to any of claims 1 to 5, wherein the support substrate (1) is selected from silicon, silica, glass, sapphire, SiC, germanium, a III-V material, a piezoelectric material or a metal, the anti-adhesive film (4) comprises an anti-adhesive material and the adhesive layer (3) comprises an organophilic material.

7. A method for manufacturing a removable substrate (400), the method comprising the steps of:
k) supplying the handle substrate (100) obtained according to any of claims 1 to 6,
l) providing a substrate (12) comprising a front face (13) and a rear face (14), the rear face (14) being capable of receiving electronic components,
m) contacting the front face (13) of the substrate (12) and an exposed face of the adhesive layer (3) of the handle substrate (100), so as to obtain a removable substrate (400) by temporarily bonding the substrate to the handle substrate (100).

8. The method for manufacturing a removable substrate (400) according to claim 7, wherein the method comprises after step m) a heat treatment step n) for strengthening the bonding between the substrate (12) and the handle substrate (100).

9. The method for manufacturing a removable substrate (400) according to any of claims 7 or 8, wherein the method comprises after step m) a step o) of applying to the rear face (14) of the substrate (12) at least one treatment step intended to manufacture electronic components, such as grinding, thinning, chemical-mechanical polishing, etching, dielectric or metal deposition, patterning, passivation, heat treatment, or a combination of at least one of these treatments.

10. The method for manufacturing a removable substrate (400) according to any of claims 8 or 9, comprising a step p) of detachment at the interface between the anti-adhesive film (4) and the adhesive layer (3) so as to detach the substrate (12).
